# EUROPEAN PATENT SPECIFICATION

(11) **EP 2 212 915 B1**
(45) Date of publication and mention of the grant of the patent: **12.09.2012**
(21) Application number: 08851302.3
(22) Date of filing: 18.11.2008
(51) Int. Cl.: H01L 31/0224

(54) **METHOD OF FABRICATION OF A BACK-CONTACTED PHOTOVOLTAIC CELL, AND BACK-CONTACTED PHOTOVOLTAIC CELL MADE BY SUCH A METHOD**
VERFAHREN ZUR HERSTELLUNG EINER PHOTOVOLTAISCHEN ZELLE MIT RÜCKSEITIGEM KONTAKT UND AUF DIESE WEISE HERGESTELLTE PHOTOVOLTAISCHE ZELLE MIT RÜCKSEITIGEM KONTAKT
PROCEDE DE FABRICATION D'UNE CELLULE PHOTOVOLTAIQUE A CONTACT ARRIERE, ET CELLULE PHOTOVOLTAIQUE A CONTACT ARRIERE FABRIQUE PAR UN TEL PROCEDE

(30) Priority: 19.11.2007 NL 2001015
(43) Date of publication of application: 04.08.2010
(73) Proprietor: Stichting Energieonderzoek Centrum Nederland, 1755 LE Petten (NL)
(72) Inventor: MIHAILETCHI, Valentin Dan, NL-1755 LE Petten (NL)
(74) Representative: Ketelaars, Maarten F.J.M.
(86) International application number: PCT/NL2008/050732
(87) International publication number: WO 2009/067005

(56) References cited:
- US-A1- 2004 261 839
- US-A1- 2004 261 840
- US-A1- 2005 172 996
- US-B1- 6 384 317
- NEU W ET AL: "Low-cost multicrystalline back-contact silicon solar cells with screen printed metallization" SOLAR ENERGY MATERIALS AND SOLAR CELLS, ELSEVIER SCIENCE PUBLISHERS, AMSTERDAM, NL, vol. 74, no. 1-4, 1 October 2002 (2002-10-01), pages 139-146, XP004376936 ISSN: 0927-0248
- NIJS J F ET AL: "Advanced Manufacturing Concepts for Crystalline Silicon Solar Cells" IEEE TRANSACTIONS ON ELECTRON DEVICES, IEEE SERVICE CENTER, PISACATAWAY, NJ, US, vol. 46, no. 10, 1 October 1999 (1999-10-01), pages 1948-1969, XP011017056 ISSN: 0018-9383

## Description

The present invention relates to a method of fabrication of a back contacted photovoltaic cell. Moreover, the present invention relates to a back contacted photovoltaic cell.

A back-contacted photovoltaic cell or solar cell, based on either a monocrystalline or polycrystalline silicon wafer, comprises a metallization scheme in which contacting electrodes of positive and negative polarity are each arranged on a back side of the solar cell. Such a metallization scheme applies either metallization wrap through (MWT) or emitter wrap through (EWT) to bring the contacting electrodes to the back side so as to have a maximal area available for photovoltaic conversion on a front side of the solar cell that in use faces a radiation source (e.g., the sun). The top layer of the solar cell connects to a front side contacting electrode on the backside of the cell by means of one or more metal plugs in holes (also known as "vias") that extend through the wafer.

The back-contacted solar cell of the prior art suffers from a relatively poor efficiency for a number of reasons.

It is known that in conventional MWT or EWT technology the conductance through the vias can be relatively small. The metallization of the vias is typically obtained by means of a screen printing process which presses metal paste into the vias. To obtain vias completely filled with metal by this method is difficult. As a result of the low conductance the efficiency of the solar cell is therefore reduced.

From International Application W05076960 it is known to improve the conductance within a via by doping the via walls using a diffusion process preceding the screen printing process. The diffusion process must be arranged to obtain a via wall with higher dopant concentration than the optimum (low) dopant concentration of the front side layer of the solar cell. Such diffusion process for the via is complex since it requires additional production steps, which may also adversely interfere with the formation of the front side layer. In particular, a relatively high dopant concentration at the front side layer of the wafer due to the doping of the via walls may enhance the recombination of minority charge carriers in the front side layer.

Also, it is known to use electroplating for metallisation of the vias in the wafer. However, this technology is relatively costly compared to screen printing. Document by W. Neu et al., Solar Energy Materials et Solar Cells 74 (2002) 139-146, describes a method to produce a solar cell. Document US 2005/172996 describes solar cell devices with vias.

It is an object of the present invention to remove or at least reduce the above disadvantages.

This object is achieved by the method of claim 1.

Advantageously, the method provides an enhancement for filling of the at least one via, due to a flow of molten first contacting metal caused by wetting and/or capillary action, which is assisted by the formation of an alloy at the walls of the at least one via.

In an aspect the method provides that the first contacting metal of the front side contacting metal paste is a dopant element for the semiconductor substrate, the dopant element causing a second conductivity type, the second conductivity type being opposite to the first conductivity type.

Advantageously, in this aspect the method allows that the walls of the at least one via can have a conductivity type different from the conductivity type of the substrate material.

In another aspect the method provides that the front side contacting metal paste comprises at least one first dopant element causing a second conductivity type, the second conductivity type being opposite to the first conductivity type. Advantageously, in this aspect the method allows that the walls of the at least one via can have a conductivity type different from the conductivity type of the substrate material.

Also, the present invention relates to a back-contacted photovoltaic cell as recited in claim 16.

Advantageous embodiments are further defined by the dependent claims.

Below, the invention will be explained with reference to some drawings, which are intended for illustration purposes only and not to limit the scope of protection as defined in the accompanying claims.
Figure 1 shows schematically a cross-section of a back-contacted photovoltaic cell in accordance with an embodiment of the present invention during an initial stage;
Figure 2 shows schematically a cross-section of the back-contacted photovoltaic cell during a next stage;
Figure 3 shows schematically a cross-section of the back-contacted photovoltaic cell during a subsequent stage;
Figure 4 shows schematically a cross-section of the back-contacted photovoltaic cell during yet a next stage;
Figure 5 shows schematically a cross-section of the back-contacted photovoltaic cell during a further stage;
Figure 6 shows schematically a cross-section of the back-contacted photovoltaic cell during yet another subsequent stage;
Figure 7 shows schematically a cross-section of the back-contacted photovoltaic cell in a further embodiment, and
Figure 8 shows a block diagram of a process in accordance with the present invention.

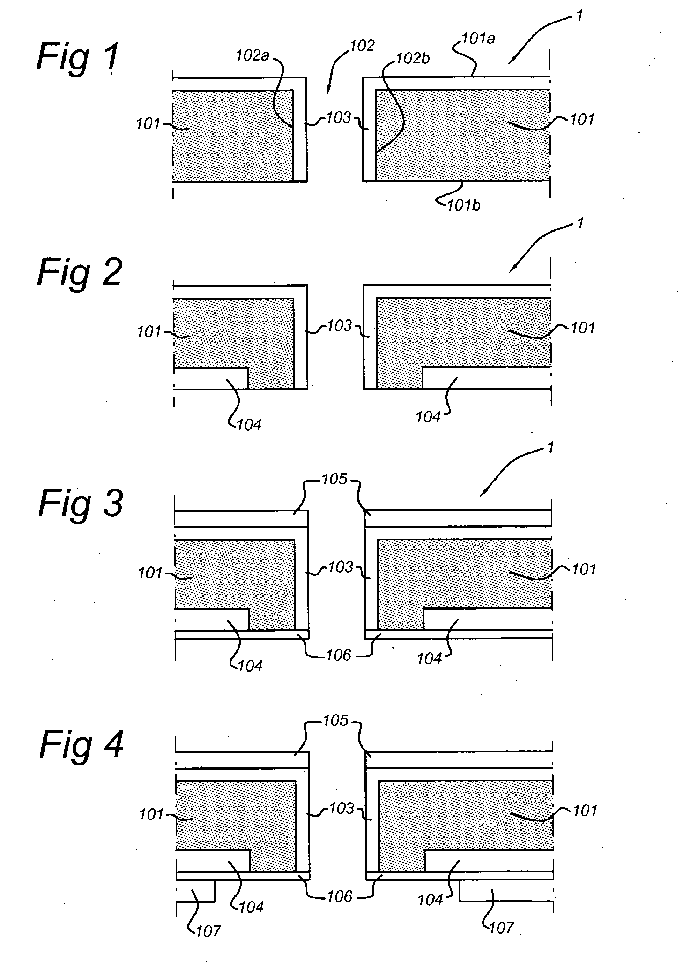

Figure 1. shows schematically a cross-section of a back-contacted photovoltaic cell 1 in accordance with an embodiment of the present invention during an initial stage.

During an initial stage of the manufacturing process, a semiconductor substrate 101 of a first conductivity type is provided.

The substrate can be either a monocrystalline wafer or a polycrystalline wafer of silicon.

The first conductivity type can be either p-type (acceptor type) or n-type (donor type). In a preferred embodiment, the first conductivity type is n-type.

In the substrate 101, one or more vias 102 are created that run from a front side 101a to a back side 101b of the substrate. Vias can be created by laser hole drilling technology.

After creating the vias 102, a top layer 103 is formed on the front side of the substrate 101 and on the walls 102a, 102b of the vias 102, and optional on part of the back side of the substrate. The top layer 103 has a second conductivity type that is opposite to the first conductivity type of the substrate 101.

In a preferred embodiment, the substrate has n-type conductivity and the top layer 103 has p-type conductivity. The p-type top layer 103 can be formed by diffusion of boron (B) as a first dopant element of p-type.

Alternatively, the first dopant element may comprise Al, Ga, or In.

The first dopant element may be formed from a vapor source or a coating source.

The coating source may be a paste or a liquid that contains the dopant. This paste or liquid can be screen printed, spin-coated or sprayed on the surface of the substrate and then can be diffused in at high temperature.

Figure 2 shows schematically a cross-section of the back-contacted photovoltaic cell 1 during a next stage.

Next, base contact regions 104 for contacting the substrate 101 are created on the back side 101b.

A mask (not shown) is used to define the regions where the base contacts 104 are to be formed.

In a preferred embodiment, in which the substrate has n-type conductivity, the base contact regions 104 are created by a diffusion of a second dopant element of n-type. The second dopant element may be phosphorous (P). The second dopant element may be formed from a vapor source or a coating source.

After defining or creating the base contact regions 104, the mask is removed.

Alternatively, the second dopant element may be applied locally on the base contact regions 104 by means of a dopant containing paste comprising n-type dopant.

Figure 3 shows schematically a cross-section of the back-contacted photovoltaic cell 1 during a subsequent stage.

Subsequently, a first dielectric layer 105 is formed on the front side of the substrate to cover the top layer 103. Typically, the first dielectric layer 105 is a silicon nitride layer which can be created by a plasma enhanced chemical vapor deposition process (PECVD). Alternatively, the dielectric layer may be formed by a sputter-deposition process or a low pressure CVD (LPCVD) process or any further process as known in the art.

Next, a second dielectric layer 106 is formed on the back side of the substrate. Typically, the second dielectric layer 106 which may have a different composition than the first dielectric layer 105 is a silicon nitride layer which can be also created by a plasma enhanced chemical vapor deposition process (PECVD).

Figure 4 shows schematically a cross-section of the back-contacted photovoltaic cell 1 during yet a next stage.

During this stage, a back side metallization pattern 107 is created on the second dielectric layer at the back side of the substrate. The back side metallization pattern 107 is arranged substantially over the base contact regions 104.

Typically, the back side metallization pattern 107 is created by screen printing of a back side contacting metal paste. Alternatively, the back side metallization pattern 107 may also be created by an other technology, such as stencil printing, inkjet printing, dispensing, decal transfer, electroplating, electroless plating (but not limited thereto). The back side metal paste of the back side metallization pattern 107 may comprise silver (Ag) as second contacting metal.

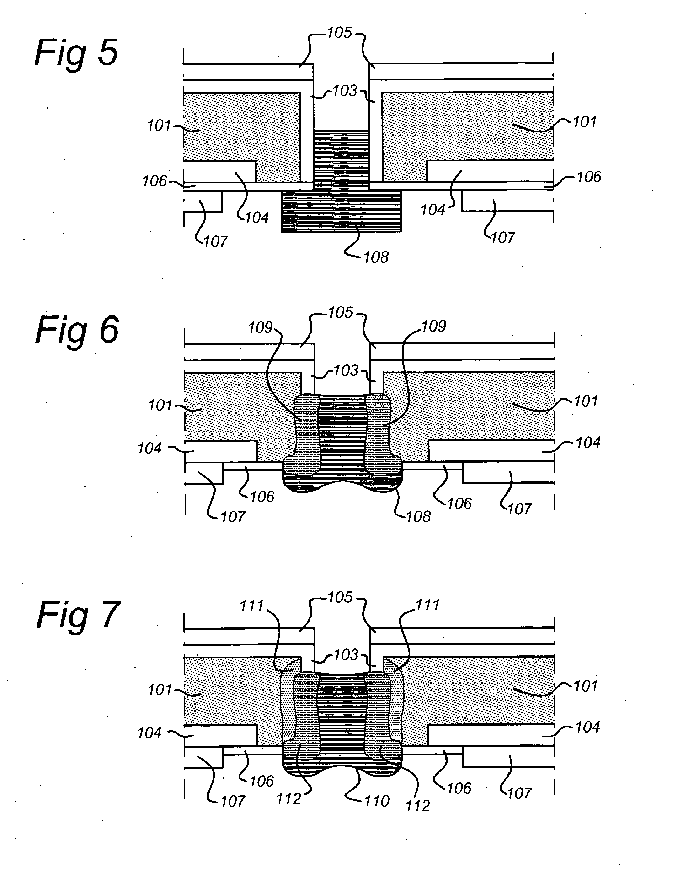

Figure 5 shows schematically a cross-section of the back-contacted photovoltaic cell 1 during a subsequent stage.

During this stage, a front side contacting metallization pattern 108 is created at the back side of the substrate. The front side contacting metallization pattern is formed over the back side via openings in such a way that the vias 102 are at least partially filled with first contacting metal.

The front side contacting metallization pattern may be created by a second screen printing process of a contacting metal paste, or by other techniques such as those mentioned above with reference to the fabrication of the back side metallisation pattern.

In a preferred embodiment, the contacting metal paste of the front side contacting metallization pattern 108 comprises aluminium (Al) as first contacting metal.

In the case of MWT (metallisation wrap through) an additional metallisation pattern (not shown here) is also applied on the front side of the substrate.

Figure 6 shows schematically a cross-section of the back-contacted photovoltaic cell during yet another subsequent stage.

During this stage, the back-contacted photovoltaic cell is heated at an elevated annealing temperature. The annealing temperature is selected so as to allow the formation of a conductive contact between the second contacting metal of the back side. contacting metallization pattern 107 and the base contact regions 104, and to cause melting of at least the first contacting metal in the contacting metal paste of the front side contacting metallization pattern 108.

The melting of the front side contacting metal paste advantageously allows filling of the vias, due to a flow of molten contacting paste material caused by wetting and/or capillary action.

Moreover, the annealing temperature may be chosen so as to have a reaction of the first contacting metal of the front side contacting metallization pattern 108 with the walls 102a, 102b of the via to form an intermetallic compound 109 (e.g., a eutectic alloy).

The via may comprise a plug of a single metal body, in case no reaction occurs with the walls. If a reaction occurs with the walls, then the via may comprise a plug that partially or fully consists of the intermetallic compound 109.

In an embodiment in which the first contacting metal paste comprises aluminium and the semiconductor substrate comprises silicon, the intermetallic compound 109 may comprise the Al-Si eutectoid. Due to the formation of a eutectic alloy at relative low liquidus temperature (about 600 °C) in the Al-Si composition system (or Al-Si phase diagram), an excellent filling of vias can be achieved, in particular due to the relative low viscosity of the eutectic liquid.

Also, it is noted that aluminium can act as a p-type dopant of silicon. As a result, the junction isolation (the isolation of the via metal from the n-type substrate 101) and the conductivity within the via wall is enhanced, which results in further improvement of the efficiency of the back-contacted photovoltaic cell 1.

In an embodiment in which the back side contacting metal paste comprises silver and the front side contacting metal paste comprises aluminium, an annealing temperature can be chosen between the melting temperature of aluminium and that of silver. In such a case, alloying of aluminium with silicon can occur, while silver paste only opens the silicon nitride layer 106 to contact the base contacts 104.

It is noted that in an alternative embodiment, the back side contacting (by annealing) of the back side contacting metal paste 107 to the base contacts 104 may be done preceding to the screen printing of the front side contacting metal paste 108 and the subsequent anneal to fill the vias with the contacting metal.

Since the annealing temperature to melt aluminium (or Al-Si alloy) is lower than the melting temperature of silver, the back side silver contacts 107 are stable during the filling of the vias.

It is noted that in a further embodiment, the metallic plug in the via may comprise a void in its centre. In that case, the plug may exhibit a (quasi-) tubular shape.

Due to annealing, the front side contacting metal paste solidifies into a front side contacting metal composition comprising the first contacting metal, the back side contacting metal paste solidifies into a back side contacting metal composition comprising the second contacting metal.

Figure 7 shows schematically a cross-section of the back-contacted photovoltaic cell in a further embodiment.

In Figure 7 entities with the same reference number as shown in the preceding figures refer to the corresponding entities.

In this embodiment, the front side contacting metal paste 108 comprises a first contacting metal and a dopant element. During an annealing procedure, both a diffusion reaction of the dopant element diffusing into the substrate material and an alloying reaction of the first contacting metal with the semiconductor substrate material can occur.

Depending on the reaction kinetics of each of these reactions, the plug in the via may comprise a doped layer 111, an intermetallic compound layer 112 and a metal body 110. The ratio of the widths will depend on the reaction kinetics at the selected annealing temperature, as will be known to the skilled person.

In an embodiment, the substrate 101 comprises n-type silicon and the front side contacting metal paste comprises aluminium and boron.

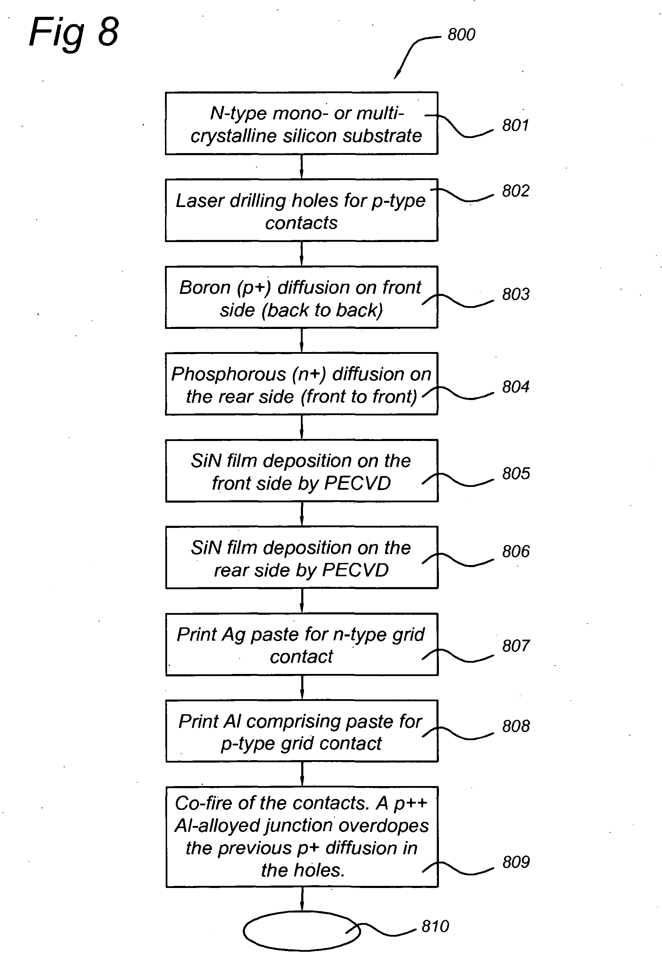

Figure 8 shows a block diagram of a manufacturing process 800 in accordance with an embodiment of the present invention.

The manufacturing process 800 of a back-contacted photovoltaic cell 1 begins at action 801, in which a n-type silicon substrate is provided. The wafer is either monocrystalline or polycrystalline.

In next action 802, holes (vias) for p-type contacts are drilled in the wafer by laser drilling.

Then, in action 803, on the front side of the wafer a top layer with p-type conductivity is formed by boron (p⁺) diffusion. This diffusion process may be carried out at elevated temperature using gaseous boron pre-cursor. At the same time, the walls of the vias are covered with a layer of p-type conductivity.

In action 804, contact regions are created on the back side 101b of the wafer by a diffusion of n-type dopant. The n-type dopant may be phosphorous (P).

In subsequent action 805, a first dielectric layer 105 is formed as passivation and anti-reflection layer to cover the top layer 103. This first dielectric layer 105 may be a silicon nitride layer which can be created by a plasma enhanced chemical vapor deposition process (PECVD).

In next action 806, a second dielectric layer 106 is formed as passivation and internal-reflection layer on the back side of the wafer. The second silicon nitride layer can be created by a plasma enhanced chemical vapor deposition process (PECVD).

In action 807, a back side (base) contacting metallization pattern 107 for contacting the back side base contacts is created on the back side of the wafer by screen printing of a back side contacting metal paste comprising silver (Ag).

Then, in action 808, a front side (emitter) contacting metallization pattern 108 is created at the back side of the wafer by screen printing of a contacting metal paste comprising aluminium as first contacting metal. The front side contacting metallization pattern is formed over the back side via openings in such a way that the vias 102 are at least partially filled with front side contacting metal paste.

Next in action 809, the wafer is annealed at an elevated annealing temperature. During annealing a conductive contact between the back side silver metallization pattern 107 and the base contact regions 104 is formed. At the same time, the contacting metal paste melts and fills the vias, due to a flow of the molten contacting metal paste material caused by wetting and/or capillary action. The aluminium of the front side contacting metal paste reacts with the silicon of the wafer and forms an intermetallic compound that covers the walls of the via. Since aluminium is a p-type dopant for silicon, the junction isolation is enhanced and the efficiency of the photovoltaic cell is improved.

In a following action 810 the wafer is cooled down and processed further to create a photovoltaic cell.

It is noted that in the above description, several intermediate process steps may be present, in particular wet- or dry chemical steps, for example for etching and cleaning. For reason of clarity these intermediate steps which are apparent to the skilled person are not discussed here.

## Claims

1. Method of manufacturing a photovoltaic cell, comprising:
- providing a semiconductor substrate of a first conductivity type;
- creating at least one via, being a hole, that extends between a front side and a back side of the semiconductor substrate;
- applying on the backside a front side contacting metal paste over the at least one via, the front side contacting metal paste comprising a first contacting metal;
- annealing the semiconductor substrate so as to melt the first contacting metal, and
during annealing, creating at least on the walls of the at least one via an alloy of the first contacting metal and the semiconductor substrate material.

2. Method according to claim 1, wherein
- after the creation of the at least one via, a layer of a second conductivity type is formed on at least the front side of the semiconductor substrate and on walls of the at least one via;
the second conductivity type being opposite to the first conductivity type.

3. Method according to any one of preceding claims 1 - 2, wherein the first contacting metal of the front side contacting metal paste is a dopant element for the semiconductor substrate, the dopant element causing a second conductivity type, the second conductivity type being opposite to the first conductivity type.

4. Method according to any one of preceding claims 1 - 3 , wherein the front side contacting metal paste comprises at least one first dopant element causing a second conductivity type, the second conductivity type being opposite to the first conductivity type.

5. Method according to claim 2, wherein, in addition to the formation of the layer of second conductivity type, the method comprises:
- forming base contact regions at the back side of the semiconductor substrate, the base contact regions being of the first conductivity type.

6. Method according to claim 2, wherein after the formation of the layer of second conductivity type, the method comprises:
- forming a first dielectric layer to cover the layer of the second conductivity type.

7. Method according to claim 5, wherein after the formation of the base contact regions at the back side of the semiconductor substrate, the method comprises:
- forming a second dielectric layer to cover the back side of the semiconductor substrate.

8. Method according to claim 7, wherein after the formation of the second dielectric layer, the method comprises:
- applying back side contacting metal paste on the base contact regions; the back side contacting metal paste comprising a second contacting metal.

9. Method according to claim 1, wherein the annealing of the semiconductor substrate being done at a temperature above at least a melting temperature of the first contacting metal.

10. Method according to claim 1, wherein the annealing of the semiconductor substrate being done at a temperature above at least a eutectic temperature of a composition system of the first contacting metal and the semiconductor substrate material.

11. Method according to claim 9 or 10, wherein the first contacting metal has a melting temperature, or a eutectic temperature in association with the substrate material, lower than a melting temperature of the second contacting metal.

12. Method according to claim 1, wherein the first conductivity type is n-type.

13. Method according to claim 9 or 10, wherein
the front side contacting metal paste comprises aluminium as first contacting metal,
the back side contacting metal paste comprises silver as second contacting metal, and
the semiconductor substrate comprises silicon.

14. Method according to claim 4, wherein the at least one first dopant element is selected from at least one of a group of boron, aluminium, gallium and indium.

15. Method according to claim 5, wherein forming base contact regions at the back side of the semiconductor substrate is done by diffusion of a second dopant element of the first conductivity type; the second dopant element being selected from at least one of a group of phosphorous, arsenic and antimony.

16. Photovoltaic cell comprising:
- a silicon semiconductor substrate of n-type;
- at least one via, being a hole, that extends from a front side to a back side of the semiconductor substrate;
- on the backside a front side contacting metal pattern over the at least one via, the front side contacting metal pattern comprising aluminum;
the at least one via comprising at least on the walls a layer of an alloy of aluminum and the silicon semiconductor substrate material.

17. Photovoltaic cell according to claim 16, wherein the photovoltaic cell comprises a layer of p-type conductivity in between the layer of the alloy and the silicon semiconductor substrate material in the at least one via, and on the front side of the silicon semiconductor substrate;

18. Photovoltaic cell according to claim 16, wherein aluminum of the front side contacting metal pattern is a dopant element for the semiconductor of the n-type conductivity, the dopant element causing a p-type conductivity.

19. Photovoltaic cell according to any one of claims 16 or 18, wherein the front side contacting metal pattern comprises boron as at least one dopant element causing p-type conductivity type.

20. Photovoltaic cell according to claim 19, wherein the first contacting metal has a melting temperature, or a eutectic temperature in association with the substrate material, lower than a melting temperature of the second contacting metal.

21. Photovoltaic cell according to any one of claims 16 - 20, wherein
the back side contacting metal pattern comprises silver as second contacting metal.

22. Photovoltaic cell according to claim 16or 21, wherein the at least one first dopant element is selected from at least one of a group of boron, aluminum, gallium and indium.

## Patentansprüche

1. Verfahren zum Herstellen einer photovoltaischen Zelle, aufweisend:
- Bereitstellen eines Halbleitersubstrats eines ersten Leitfähigkeitstyps;
- Erzeugen von mindestens einer Durchkontaktierung ausgebildet als Loch, das sich zwischen einer Vorderseite und einer Rückseite des Halbleitersubstrats erstreckt;
- Aufbringen einer Metallpaste, die in Kontakt mit der Vorderseite steht, auf die Rückseite über die mindestens eine Durchkontaktierung, wobei die die Vorderseite kontaktierende Metallpaste ein erstes Kontaktmetall aufweist;
- Erwärmen des Halbeitersubstrats, um das erste Kontaktmetall zu schmelzen; und
- während des Erwärmens Erzeugen einer Legierung des ersten Kontaktmetalls und des Halbleiter-Substratmaterials zumindest an den Wänden der mindestens einen Durchkontaktierung.

2. Verfahren nach Anspruch 1, wobei
- nach der Erstellung der mindestens einen Durchkontaktierung eine Schicht eines zweiten Leitfähigkeitstyps auf zumindest der Vorderseite des Halbleitersubstrats und an den Wänden der mindestens einen Durchkontaktierung ausgebildet wird; wobei der zweite Leitfähigkeitstyp entgegengesetzt zu dem ersten Leitfähigkeitstyp angeordnet ist.

3. Verfahren nach einem der vorhergehenden Ansprüche 1 - 2, wobei das erste Kontaktmetall der die Vorderseite kontaktierende Metallpaste ein Dotierelement für das Halbleitersubstrat ist, und das Dotierelement einen zweiten Leitfähigkeitstyp verursacht, wobei der zweite Leitfähigkeitstyp entgegengesetzt zu dem ersten Leitfähigkeitstyp angeordnet ist.

4. Verfahren nach einem der vorhergehenden Ansprüche 1 - 3, wobei die mit der Vorderseite in Kontakt stehende Metallpaste mindestens ein erstes Dotierelement aufweist und dabei einen zweiten Leitfähigkeitstyp verursacht, wobei der zweite Leitfähigkeitstyp entgegengesetzt zu dem ersten Leitfähigkeitstyp angeordnet ist.

5. Verfahren nach Anspruch 2, wobei das Verfahren zusätzlich zu der Ausbildung der Schicht des zweiten Leitfähigkeitstyps aufweist:
- das Bilden von Basiskontaktzonen an der Rückseite des Halbleitersubstrats, wobei die Basiskontaktzonen mit dem ersten Leitfähigkeitstyp ausgebildet sind.

6. Verfahren nach Anspruch 2, wobei das Verfahren nach dem Bilden der Schicht des zweiten Leitfähigkeitstyps aufweist:
- Bilden einer ersten dielektrischen Schicht, um die Schicht des zweiten Leitfähigkeitstyps zu überdecken.

7. Verfahren nach Anspruch 5, wobei das Verfahren nach dem Bilden der Basiskontaktzonen an der Rückseite des Halbleitersubstrats aufweist:
- Bilden einer zweiten dielektrischen Schicht, um die Rückseite des Halbleitersubstrats zu überdecken.

8. Verfahren nach Anspruch 7, wobei das Verfahren nach dem Bilden der zweiten dielektrischen Schicht aufweist:
- Aufbringen einer in Kontakt mit der Rückseite stehende Metallpaste auf die Basiskontaktzonen; wobei die die Ruckseite kontaktierende Metallpaste ein zweites Kontaktmetall aufweist.

9. Verfahren nach Anspruch 1, wobei das Erwärmen des Halbleitersubstrats bei einer Temperatur oberhalb von zumindest einer Schmelztemperatur des ersten Kontaktmetalls durchgeführt wird.

10. Verfahren nach Anspruch 1, wobei das Erwärmen des Halbleitersubstrats bei einer Temperatur oberhalb zumindest einer eutektischen Temperatur einer Zusammensetzung des ersten Kontaktmetalls und des Halbleitersubstratmaterials durchgeführt wird.

11. Verfahren nach Anspruch 9 oder 10, wobei das erste Kontaktmetall eine Schmelztemperatur, oder eine eutektische Temperatur in Verbindung mit dem Substratmaterial, aufweist, die niedriger als eine Schmelztemperatur des zweiten Kontaktmetalls ist.

12. Verfahren nach Anspruch 1, wobei der erste Leitfähigkeitstyp ein n-Typ ist.

13. Verfahren nach Anspruch 9 oder 10, wobei die die Vorderseite kontaktierende Metallpaste als erstes Kontaktmetall Aluminium aufweist, die die Rückseite kontaktierende Metallpaste als zweites Kontaktmetall Silber aufweist, und das Halbleitersubstrat Silizium aufweist.

14. Verfahren nach Anspruch 4, wobei das mindestens eine erste Dotierelement aus mindestens einem Element aus einer Gruppe von Bor, Aluminium, Gallium und Indium ausgewählt wird.

15. Verfahren nach Anspruch 5, wobei das Bilden von Basiskontaktzonen an der Rückseite des Halbleitersubstrats durch Diffusion eines zweiten Dotierelements des ersten Leitfähigkeitstyps erfolgt, wobei das zweite Dotierelement aus mindestens einem Element aus einer Gruppe von Phosphor, Arsen und Antimon ausgewählt wird.

16. Photovoltaische Zelle, aufweisend:
- ein Silizium-Halbleitersubstrat vom n-Typ;
- mindestens eine Durchkontaktierung als Loch ausgebildet, das sich von einer Vorderseite zu einer Rückseite des Halbleitersubstrats erstreckt;
- auf der Rückseite ein die Vorderseite kontaktierendes Metallmuster über der mindestens eine Durchkontaktierung, wobei das die Vorderseite kontaktierende Metallmuster Aluminium aufweist;
wobei die mindestens eine Durchkontaktierung wenigstens an den Wänden eine Schicht aus einer Legierung aus Aluminium und Silizium-Halbleitersubstratmaterial aufweist.

17. Photovoltaische Zelle nach Anspruch 16, wobei die photovoltaische Zelle eine Schicht aus p-Typ-Leitfähigkeit zwischen der Schicht der Legierung und des Silizium-Halbleitersubstratmaterials in der mindestens eine Durchkontaktierung und an der Vorderseite des Silizium-Halbleitersubstrats aufweist.

18. Photovoltaische Zelle nach Anspruch 16, wobei Aluminium des die Vorderseite kontaktierenden Metallmusters ein Dotierelement für die Halbleiter der n-Typ-Leitfähigkeit ist, wobei das Dotierelement eine p-Typ-Leitfähigkeit verursacht.

19. Photovoltaische Zelle nach einem der Ansprüche 16 oder 18, wobei das die Vorderseite kontaktierende Metallmuster Bor als mindestens ein Dotierelement, das einen p-Typ-Leitfähigkeittyp verursacht, aufweist.

20. Photovoltaische Zelle nach Anspruch 19, wobei das erste Kontaktmetall eine Schmelztemperatur, oder eine eutektischen Temperatur in Verbindung mit dem Substratmaterial, niedriger als eine Schmelztemperatur des zweiten Kontaktmetalls aufweist.

21. Photovoltaische Zelle nach einem der Ansprüche 16 - 20, wobei das die Ruckseite kontaktierende Metallmuster Silber als zweites Kontaktmetall aufweist.

22. Photovoltaische Zelle nach Anspruche 16 oder 21, wobei das mindestens eine erste Dotierelement aus mindestens einem Element von einer Gruppe Bor, Aluminium, Gallium und Indium ausgewählt wird.

## Revendications

1. Procédé de fabrication d'une cellule photovoltaïque, comprenant :
- la fourniture d'un substrat semi-conducteur d'un premier type de conductivité ;
- la création d'au moins un via, étant un trou, qui s'étend entre une face avant et une face arrière du substrat semi-conducteur ;
- l'application sur la face arrière d'une pâte métallique de contact de la face avant sur au moins un via, la pâte métallique de contact de la face avant comprenant un premier métal de contact ;
- le recuit du substrat semi-conducteur afin de faire fondre le premier métal de contact, et
pendant le recuit, la création d'au moins sur les parois d'au moins un via d'un alliage du premier métal de contact et du matériau de substrat semi-conducteur.

2. Procédé selon la revendication 1, dans lequel :
- après la création d'au moins un via, une couche d'un second type de conductivité est formée sur au moins la face avant du substrat semi-conducteur et sur des parois d'au moins un via ;
le second type de conductivité étant opposé au premier type de conductivité.

3. Procédé selon l'une quelconque des revendications précédentes 1 à 2, dans lequel le premier métal de contact de la pâte métallique de contact de face avant est un élément dopant pour le substrat semi-conducteur, l'élément dopant produisant un second type de conductivité, le second type de conductivité étant opposé au premier type de conductivité.

4. Procédé selon l'une quelconque des revendications 1 à 3, dans lequel la pâte métallique de contact de face avant comprend au moins un premier élément dopant produisant un second type de conductivité, le second type de conductivité étant opposé au premier type de conductivité.

5. Procédé selon la revendication 2, dans lequel, en plus de la formation de la couche de second type de conductivité, le procédé comprend :
- la formation de régions de contact de base sur la face arrière du substrat semi-conducteur, les régions de contact de base étant du premier type de conductivité.

6. Procédé selon la revendication 2, dans lequel après la formation de la couche de second type de conductivité, le procédé comprend :
- la formation d'une première couche diélectrique pour couvrir la couche de second type de conductivité.

7. Procédé selon la revendication 5, dans lequel après la formation des régions de contact de base sur la face arrière du substrat semi-conducteur, le procédé comprend :
- la formation d'une seconde couche diélectrique pour couvrir la face arrière du substrat semi-conducteur.

8. Procédé selon la revendication 7, dans lequel après la formation de la seconde couche diélectrique, le procédé comprend :
- l'application d'une pâte métallique de contact de face arrière sur les régions de contact de base ; la pâte métallique de contact de face arrière comprenant un second métal de contact.

9. Procédé selon la revendication 1, dans lequel le recuit du substrat semi-conducteur étant fait à une température au-dessus d'au moins une température de fusion du premier métal de contact.

10. Procédé selon la revendication 1, dans lequel le recuit du substrat semi-conducteur étant fait à une température au-dessus d'au moins une température eutectique d'un système de composition du premier métal de contact et du matériau de substrat semi-conducteur.

11. Procédé selon la revendication 9 ou 10, dans lequel le premier métal de contact a une température de fusion, ou une température eutectique en association avec le matériau de substrat, inférieure à une température de fusion du second métal de contact.

12. Procédé selon la revendication 1, dans lequel le premier type de conductivité est du type n.

13. Procédé selon la revendication 9 ou 10, dans lequel :
la pâte métallique de contact de face avant comprend de l'aluminium comme premier métal de contact,
la pâte métallique de contact de face arrière comprend de l'argent comme second métal de contact, et
le substrat semi-conducteur comprend du silicium.

14. Procédé selon la revendication 4, dans lequel le au moins un premier élément dopant est sélectionné à partir d'au moins un d'un groupe de bore, d'aluminium, de gallium et d'indium.

15. Procédé selon la revendication 5, dans lequel la formation de régions de contact de base sur la face arrière du substrat semi-conducteur est faite par diffusion d'un second élément dopant du premier type de conductivité ; le second élément dopant étant sélectionné à partir d'au moins un d'un groupe de phosphore, d'arsenic et d'antimoine.

16. Cellule photovoltaïque comprenant :
- un substrat semi-conducteur de silicium de type n ;
- au moins un via, étant un trou, qui s'étend de la face avant à la face arrière du substrat semi-conducteur ;
- sur la face arrière un motif métallique de contact de face avant sur au moins un via, le motif métallique de contact de face avant comprenant de l'aluminium ;
le au moins un via comprenant au moins sur les parois d'une couche d'un alliage de matériau de substrat de semi-conducteur d'aluminium et de silicium.

17. Cellule photovoltaïque selon la revendication 16, dans laquelle la cellule photovoltaïque comprend une couche de conductivité de type p entre la couche de l'alliage et le matériau de substrat semi-conducteur de silicium dans au moins un via, et sur la face avant du substrat semi-conducteur de silicium.

18. Cellule photovoltaïque selon la revendication 16, dans laquelle l'aluminium du motif métallique de contact de face avant est un élément dopant pour le semi-conducteur de la conductivité de type n, l'élément dopant produisant à une conductivité de type p.

19. Cellule photovoltaïque selon l'une quelconque des revendications 16 ou 18, dans laquelle le motif métallique de contact de face avant comprend du bore comme au moins un élément dopant produisant à un type de conductivité de type p.

20. Cellule photovoltaïque selon la revendication 19, dans laquelle le premier métal de contact a une température de fusion, ou une température eutectique en association avec le matériau de substrat, inférieure à une température de fusion du second métal de contact.

21. Cellule photovoltaïque selon l'une quelconque des revendications 16 à 20, dans laquelle le motif métallique de contact de face arrière comprend de l'argent comme second métal de contact.

22. Cellule photovoltaïque selon la revendication 16 ou 21, dans laquelle le au moins un élément dopant est sélectionné à partir d'au moins un d'un groupe de bore, d'aluminium, de gallium et d'indium.
